Europäisches Patentamt

(19) European Patent Office

Office européen des brevets

(11) Publication number: **0 063 242**
**B1**

(12) **EUROPEAN PATENT SPECIFICATION**

(45) Date of publication of patent specification: **13.08.86**

(21) Application number: **82102222.5**

(22) Date of filing: **18.03.82**

(51) Int. Cl.⁴: **H 03 M 9/00**

(54) Data handling systems with serial to parallel conversion interfaces.

(30) Priority: **20.04.81 US 255981**

(43) Date of publication of application:
**27.10.82 Bulletin 82/43**

(45) Publication of the grant of the patent:
**13.08.86 Bulletin 86/33**

(84) Designated Contracting States:
**DE FR GB**

(56) References cited:
**FR-A-1 334 359**
**US-A-3 946 379**
**US-A-4 072 987**
**US-A-4 284 953**

**IBM TECHNICAL DISCLOSURE BULLETIN, vol.
14, no. 2, July 1971, page 653, New York (USA);
C. WILLIAMS: "Deserializer".**

**IBM TECHNICAL DISCLOSURE BULLETIN, vol.
23, no. 2, July 1980, pages 516-517, New York
(USA); R.A. SCHAADT: "Shift register data
deserialization without a counter".**

(73) Proprietor: **International Business Machines
Corporation
Old Orchard Road
Armonk, N.Y. 10504 (US)**

(72) Inventor: **Dunn, Edwin Charles
8000 E. Hardy Street
Tucson Arizona 85715 (US)**

(74) Representative: **Grant, Iain Murray
IBM United Kingdom Patent Operations Hursley
Park
Winchester, Hants, SO21 2JN (GB)**

EP 0 063 242 B1

## Description

The present invention relates to data handling systems with serial to parallel conversion interfaces. The term "handling" is used to encompass "storing" and "transmission".

The present invention relates to problems of reliable interface control and comprises a mechanism for dynamically delimiting the serial read data after it is received by the rotation shift register, whereby a reliable indication is given that a symbol or fixed pattern of data has been assembled in the serial shift register, and can be offloaded in parallel data format into a holding register for resynchronization with a putative system read clock.

It is well known that magnetic recording applications utilize data in serial data format for multichannel systems. Such data is necessarily converted from the serial form to parallel data format for utilization. A common technique for transmitting the data from serial form to parallel form is to insert the serial data into a shift register which is stepped or shifted a predetermined number of times until a symbol or fixed pattern of data is then offloaded from the shift register in parallel to a holding register, where it can be stored or processed by other apparatus of the system.

Registers capable of performing such an operation are generally referred to as 90° rotation registers. For example, U.S. Patent 3,760,382 to Itoh discloses a typical series parallel shift register.

U.S. Patent 3,675,049 to Haven describes a variable digital delay system, wherein a serial stream is allocated between multiple channels.

U.S. Patent 3,885,167 to Berglund utilizes apparatus for connecting between series and parallel data streams.

All such prior art systems appear to suffer from the requirement that a separate counter or clock must be utilized to monitor the position of the data during the detection or transfer process.

To offset this, arrangements such as those set forth in US—A—3,946,379, introduce a terminal non-data stage, the switching of which stage indicates that the shift register holds a complete data entity. The contents of the data stages of the shift register, except for the first, are reset to a particular pattern on each gating of data out of the shift register. Where the data records are interleaved with resynchronizing patterns, this automatic resetting of the shift register stages fails.

Accordingly, the present invention provides a data handling system including an interface on the input side of which the data is in serial format of fixed length records preceded by fixed resynchronizing patterns and on the output side of which data is in parallel format, the interface being defined by a shift register type of serial to parallel converter having clocking logic responsive to received signals to clock the shift register, the shift register having a length equal to the fixed record length plus one extra terminal non-data stage at the output end thereof, the clocking logic being responsive to the presence of a flag in the terminal non-data stage to gate out in parallel the data contained in the data of the shift register characterized in that the clocking logic responds to the receipt of a resynchronizing pattern by the shift register to enter a flag into the second stage, from the input, of the shift register.

The present invention will be described further by way of example with reference to an embodiment thereof, in a specific context and particularly timed to that context though the invention is not so restricted, as illustrated in the accompanying drawings in which:—

Figure 1 illustrates the serial data format of the context; and

Figure 2 is a schematic block diagram of the rotation shift register and clocking logic.

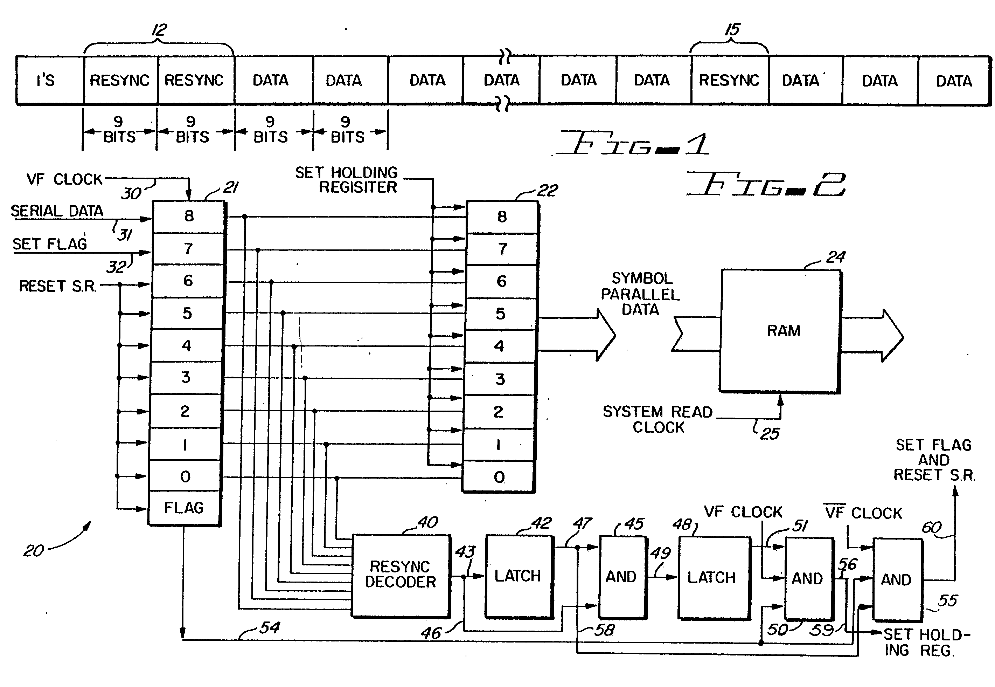

Figure 1 illustrates data in serial format with a double-fixed pattern fixed-length code 12 used to identify the beginning of data. The double-fixed pattern comprises two resynch patterns of nine bits each. A similar code is used to identify the end of data. Between the double-fixed patterns defining beginning and end of data, the data is recorded in fixed length, nine bit increments. Every 72-bit data increment, a fixed pattern is inserted for resynching, as for example, by means of code 15.

Referring now to Figure 2, a system 20 is illustrated comprising a shift register 21 which is designated as a data shift register, and a shift register 22 which is designated as a holding register. The shift registers each include corresponding bit positions interconnected by electrical conductors, whereby data can be shifted in parallel from register 21 to register 22 when a fixed pattern of data has been assembled. In the particular system illustrated, registers 21, 22 have bit positions 0—8. Thus, each register can hold a nine-bit pattern.

A memory element such as a random access memory 24 is also provided downstream of holding register 22, where it is adapted to receive data in symbol parallel form from holding register 22. The data is normally retained in the RAM 24 for an interim interval, whereafter it is offloaded to other parts of the read data flow system. Accordingly, RAM 24 is adapted to receive a system read clocking signal on input 25.

Referring to register 21, a variable frequency clock signal input 30 is provided to the register and a serial data input 31 is also provided. Input 31 is adapted to receive serial data from a predetermined channel of the system. A set flag input 32 is provided to cell 7 of the register and reset shift register inputs are provided to the flag cell, as well as to cells 0—6 of the shift register. In addition to an output from each cell to the corresponding cell of register 22, each of cells 0—8 has an output connected to an input of a resynchronization decoder 40.

The resynchronization decoder is a conventional circuit adapted to sense the presence of a fixed pattern of data in and resynch the data. Upon receiving a full data pattern, the resynchronization decoder provides an output to a latch 42 via conductor 43 and an output to an AND gate 45 via a conductor 46. AND gate 45 has a second input, received via conductor 47 from latch 42. The output of AND gate 45 is received as an input to a latch 48 via conductor 49.

Latch 42 is used to retain the presence of the first fixed pattern, and latch 48 is used to retain the second fixed pattern, immediately following the first, identifying the beginning. If latch 42 is set and a flag is detected without the second pattern, latch 42 is reset (logic not shown) and the search for beginning starts again.

The output of latch 48 is provided as one input to an AND gate 50 via a conductor 51. The other inputs to gate 50 are flag signals received from the flag cell of register 21 via a conductor 54 and V.F. clock.

AND gate 55 receives an input comprising the flag signal via conductor 54. AND gate 55 also receives a second input from latch 42 via conductor 58 and a third input, not V.F. clock. The output of AND gate 50 comprises a set holding register signal via conductor 59, and the output of AND gate 55 comprises a set flag and reset shift register signal via conductor 60.

In operation, the serial data from a given channel is provided to register 21 where it is to be received and rotated 90 degrees to obtain a parallel data format. Since the data is recorded in a serial format, with a double-fixed pattern fixed-length code, means are provided to identify the beginning of data and end of data. In the data recovery scheme, the data is delimited by the insertion of a flag bit after the first fixed pattern is detected. This is accomplished by the set flag signal.

The shift register 21 is then reset by the reset shift register signal and shifted nine times by subsequent serial data input signals. Upon each shifting operation of register 21, the flag bit is incremented through one cell of register 21. Upon being incremented nine times, the flag bit reaches the flag cell and provides an indication that a full symbol or fixed pattern of data has been assembled and can be offloaded into the holding register. Accordingly, the flag cell provides a flag signal via conductor 54 to AND gates 50 and 55.

If the resynch decoder 40 sets latch 42, AND gate 45 and latch 48, a positive signal is also present on input 51 to gate 50. That positive signal, along with the V.F. clock signal and the flag signal via conductor 54 cause gate 50 to generate the set holding register signal, whereby data is offloaded from register 21 to the holding register 22. If the resynch decoder 40 sets latch 42 and the flag signal via conductor 54 is present together with not V.F. clock input, AND gate 55 causes the set flag and reset shift register signal to be applied. The cycle then begins again. However, once latches 42 and 48 have been set, these signals are retained. Therefore, only the presence of the flag signal and the V.F. clock signals are required to complete a cycle.

In the event that any cell of register 21 becomes stuck as a 1 or as a 0, the flag bit will cause that channel to overrun all of the other tracks, thereby causing an error. If the cell is stuck as a 0, the track being read will stop and be dead tracked. In either event, the next cycle initiated from that track will not detect a beginning of data and a dead track signal will result. Accordingly, the flag bit approach provides an indication of improper function or delimiting of data.

It should be noted that the V.F. clock and not V.F. clock signals are derived from a single source. This allows the advantageous operation of both registers and the associated control circuitry from the single clock source, thereby accommodating requirements of single clock systems.

**Claims**

1. A data handling system including an interface on the input side of which the data is in serial format of fixed length records preceded by fixed resynchronizing patterns and on the output side of which data is in parallel format, the interface being defined by a shift register type of serial to parallel converter having clocking logic (generally 40 to 60) responsive to received signals to clock the shift register (21), the shift register having a length equal to the fixed record length plus one extra terminal non-data stage (FLAG) at the output end thereof, the clocking logic being responsive (at 50) to the presence of a flag in the terminal non-data stage to gate out in parallel the data contained in the data stages of the shift register characterized in. that the clocking logic responds to the receipt of a resynchronizing pattern by the shift register to enter a flag into the second stage, from the input, of the shift register.

2. A system as claimed in claim 1 in which the clocking logic is responsive to the input to clock all signals received into and through the shift register, a decoder being provided which is responsive (at 40) to the contents of selected shift register stages, assuming their states to indicate the resynchronization pattern, the clocking logic being responsive to the decoder at its first response at any given occasion to insert the flag and to clear the succeeding stages of the shift register without gating out the stage contents in parallel, at its second immediately occuring response together with the detection of the flag in the terminal non-data stage, to perform the same function and to switch to a data mode, whereafter, in the absence of malfunction, the same function will be performed, on each detection of the flag in the terminal non-data stage without the decoder responding, together with gating of the contents of the data stages of the shift register in parallel.

3. A system as claimed in claim 2 wherein a latch (48) is provided set on detection of a resynchronization pattern and reset on gating out of a record to latch a data handling mode of operation, the output gating being the AND function of the set latch and the presence of the flag signal in the terminal non-data stage.

## Patentansprüche

1. Datenverarbeitungsvorrichtung mit einer Schnittstelle, an deren Eingangsseite die Daten serielles Format von Datensätzen fester Länge aufweisen, denen bestimmte resynchronisierende Muster vorausgehen, und an deren Ausgangsseite die Daten paralleles Format aufweisen, wobei die Schnittstelle durch ein Schieberegister in Form eines Serien-Parallel-Wandlers definiert ist, welcher eine Taktlogik (gewöhnlich 40—60) aufweist, die auf erhaltene Signale durch Takten des Schieberegisters (21) reagiert, wobei die Länge des Schieberegisters gleich der festen Datensatzlänge plus einer zusätzlichen abschließenden nicht-Daten-Stufe (FLAG) an dessen Ausgang ist, und wobei die Taktlogik (bei 50) auf eine Marke in der nicht-Daten-Stufe reagiert, indem sie die in den Datenstufen des Schieberegisters befindliche Daten parallel ausgibt, dadurch gekennzeichnet, daß die Taktlogik auf den Empfang eines resynchronisierenden Musters durch das Schieberegister reagiert und eine Marke in die zweite Stufe des Schieberegisters vom Eingang her einsetzt.

2. Vorrichtung nach Anspruch 1, dadurch gekennzeichnet, daß die Taktlogik auf den Eingang reagiert und alle erhaltenen Signale in das und durch das Schieberegister taktet, wobei ein Dekoder vorgesehen ist, welcher (bei 40) auf den Inhalt ausgewählter Schieberegisterstufen reagiert, in der Annahme, das diese Stufen das resynchronisierende Muster anzeigen, wobei die Taktlogik bei der ersten auftretenden Reaktion des Dekoders dahingehend reagiert, daß sie die Marke einsetzt und die nachfolgenden Stufen des Schieberegisters ohne Parallel-Herausführung des Stufeninhalts löscht und bei seiner zweiten unmittelbar auftretenden Reaktion zusammen mit dem Entdecken der Marke in der nicht-Daten-Stufe die gleiche Funktion durchführt und in einen Datenmodus schaltet, wonach — sofern keine Störungen auftreten — die gleiche Funktion bei jedem Entdecken der Marke in der nicht-Daten-Stufe ohne Reaktion des Dekoders durchgeführt wird mit gleichzeitigem parallelen Herausführen des Inhalts der im Schieberegister befindlichen Datenstufen.

3. Vorrichtung nach Anspruch 2, dadurch gekennzeichnet, daß ein Zwischenspeicher (48) nach dem Entdecken eines resynchronisierenden Musters gesetzt wird und nach dem Herausleiten eines Datensatzes rückgesetzt wird, um einen Datenverarbeitungsmodus zu sperren, wobei das Herausführen des Ausgangs die UND-Funktion des gesetzten Signalspeichers und des Vorhandenseins der Marke in der nicht-Daten-Stufe darstellt.

## Revendications

1. Système de traitement de données comprenant une interface du côté entrée de laquelle les données se trouvent en structure sérielle sous forme d'enregistrements de longueur fixe, pre-1cédés de configurations fixes de resynchronisation, et du côté sortie de laquelle les données sont en structure en parallèle, l'interface étant définie par un registre à décalage du type convertisseur série-parallèle ayant une logique de synchronisation (généralement de 40 à 60) sensible à des signaux qu'elle reçoit dans le but de synchroniser le registre (21) à décalage, ce registre à décalage ayant une longueur égale à la longueur fixe d'enregistrement augmentée d'une phase finale supplémentaire ne comportant pas d'information (INDICATEUR) à l'extrémité de sortie du registre, la logique de synchronisation réagissant (à 50) à la présence d'un indicateur dans la phase finale sans données pour déclencher la sortie en parallèle des données contenues dans les phases à données du registre à décalage, le système étant caractérisé en ce que la logique de synchronisation réagit à la réception d'une configuration de resynchronisation par le registre à décalage pour introduire un indicateur dans la seconde phase à partir de l'entrée du registre à décalage.

2. Système suivant la revendication 1, dans lequel la logique de synchronisation réagit à l'entrée pour pointer tous les signaux reçus dans le registre à décalage et le traversant, un décodeur étant intercalé et réagissant (à 40) aux contenus de phases choisies du registre à décalage, tenant compte de leur état pour indiquer la configuration de la resynchronisation, la logique de synchronisation réagissant au décodeur à sa première réponse à toute occasion donnée pour interposer l'indicateur et vider les phases suivantes du registre à décalage sans déclencher la sortie des contenus des phases en parallèle, à sa seconde réponse, survenant immédiatement après, concomitante de la détection de l'indicateur dans la phase finale sans données, pour remplir la même fonction et faire passer à un mode de données, après quoi, à condition qu'il n'y ait pas de défectuosité de fonctionnement, le même processus de fonctionnement, se déroulera à chaque détection de l'indicateur en phase finale sans données sans que le décodeur réagisse, en même temps qu'un déclenchement en sortie des contenus des phases de données en parallèle du registre à décalage.

3. Système suivant la revendication 2, caracte-1risé en ce qu'une bascule (48) est prévue, positionnée en vue de la détection d'une configuration de resynchronisation et remise au point initial après déclenchement en sortie d'un enregistrement pour déclencher un mode d'opération de traitement de données, le déclenchement en sortie étant le fonctionnement ET de la bascule positionnée avec présence du signal d'indicateur de la phase finale sans données.

**Fig-1**

| I'S | RESYNC | RESYNC | DATA | DATA | DATA | DATA | DATA | DATA | RESYNC | DATA | DATA | DATA |

12

15

9 BITS  9 BITS  9 BITS  9 BITS

**Fig-2**

VF CLOCK — 30

SERIAL DATA — 31

SET FLAG — 32

RESET S.R.

21

8 7 6 5 4 3 2 1 0 FLAG

20

SET HOLDING REGISTER

22

8 7 6 5 4 3 2 1 0

SYMBOL PARALLEL DATA

RAM — 24

SYSTEM READ CLOCK — 25

SET FLAG AND RESET S.R.

RESYNC DECODER — 40

43

LATCH — 42

47

AND — 45

49

LATCH — 48

VF CLOCK — 51

AND

56

VF CLOCK — 60

AND

55

54

46

58

50  59

SET HOLDING REG.

0 063 242